Europäisches Patentamt

European Patent Office

Office européen des brevets

(11) Veröffentlichungsnummer: **0 046 550**
**A1**

(12) **EUROPÄISCHE PATENTANMELDUNG**

(21) Anmeldenummer: **81106343.7**

(22) Anmeldetag: **14.08.81**

(51) Int. Cl.³: **G 11 C 11/34**
**G 11 C 17/00**

(30) Priorität: **27.08.80 DE 3032295**

(43) Veröffentlichungstag der Anmeldung:
**03.03.82 Patentblatt 82/9**

(84) Benannte Vertragsstaaten:
**FR GB**

(71) Anmelder: **SIEMENS AKTIENGESELLSCHAFT Berlin und München**
**Postfach 22 02 61**
**D-8000 München 22(DE)**

(72) Erfinder: **Oldham, William G., Prof.**
**762, Colusa Avenue**
**El Cerreto California 94530(US)**

(54) **Monolithisch integrierter Festwertspeicher.**

(57) Monolithisch integrierter Festwertspeicher mit parallelen Wortleitungen, diese kreuzenden Leseleitungen und an selektierten Kreuzungsstellen angeordneten Kopplungselementen, die über die Wortleitungen ansteuerbar sind und die Leseleitungen im leitenden Zustand mit dem Bezugspotential beschalten. Angestrebt wird hierbei eine flächensparende, auch nach dem Aufbringen der Metallisierungsebenen durchführbare Programmierung. Dies wird dadurch erreicht, daß an allen Kreuzungsstellen Feldeffekttransistoren vorgesehen sind, von denen die an den (nicht) selektierten Kreuzungsstellen angeordneten mittels eines ihre Kanalbereiche abtastenden Elektronenstrahls bezüglich der Ladungszustände ihrer Gate-Isolierschichten verändert werden, sodaß ihre hierdurch bedingten Einsatzspannungsänderungen ihren (Nicht-) Einsatz als Kopplungselemente bestimmen. Der Anwendungsbereich umfaßt programmierbare Festwertspeicher.

FIG 2

0046550

SIEMENS AKTIENGESELLSCHAFT
Berlin und München

Unser Zeichen
VPA 80 P 8 0 4 0. E

## Monolithisch integrierter Festwertspeicher

Die Erfindung bezieht sich auf einen monolithisch integrierten Festwertspeicher nach dem Oberbegriff des Patentanspruchs 1.

Ein solcher Festwertspeicher (ROM) ist aus dem Buch von Luecke, Mize und Carr "Semiconductor Memory Design and Application", Verlag McGraw-Hill Kogakusha Ltd., Tokyo 1973, Seiten 154 bis 155, insbesondere Figur 6.15 bekannt. Hierbei sind aber als Kopplungselemente dienende Feldeffekttransistoren nur an den selektierten Kreuzungsstellen vorgesehen, nicht jedoch an den übrigen. Die Selektion der Kreuzungsstellen bzw. die Programmierung des Festwertspeichers erfordert somit eine entsprechende Ausbildung derjenigen Masken, die bei der Definition der Feldeffekttransistoren verwendet werden. Die Programmierung erfolgt dementsprechend vor dem Aufbringen der Metallisierungen.

Auf den Seiten 168 und 169 des genannten Buches sind andere programmierbare Festwertspeicher beschrieben, deren Kopplungselemente mit Verbindungsgliedern in Serie geschaltet sind, die zum Zwecke des Programmierens unterbrochen werden können, um bestimmte Kopplungselemente unwirksam zu schalten. Die Verbindungsglieder erhöhen aber den Bedarf an Halbleiterfläche beträchtlich.

Der Erfindung liegt die Aufgabe zugrunde, einen Festwertspeicher der eingangs genannten Art anzugeben, dessen Kopplungselemente in einfacher Weise ohne eine wesentliche Vergrößerung des Flächenbedarfs auch nach dem Aufbringen der

St 1 Dxl / 25.08.1980

Metallisierungsebene(n) erfolgen kann, so daß der Her-.
stellungsprozeß einschließlich des Definierens der metallischen Belegungen hiervon nicht beeinflußt wird.

Die Erfindung wird nachfolgend an Hand der Zeichnung näher erläutert. Dabei zeigt:

Fig. 1 das Schaltbild eines ersten nach der Erfindung ausgebildeten Festwertspeichers,
Fig. 2 eine Teilschaltung von Fig. 1 im Querschnitt,
Fig. 3 eine erste alternative Ausbildung der Teilschaltung
    von Fig. 2
Fig. 4 eine zweite alternative Ausbildung der Teilschaltung
    von Fig. 2 und
Fig. 5 das Schaltbild eines zweiten nach der Erfindung
    ausgebildeten Festwertspeichers.

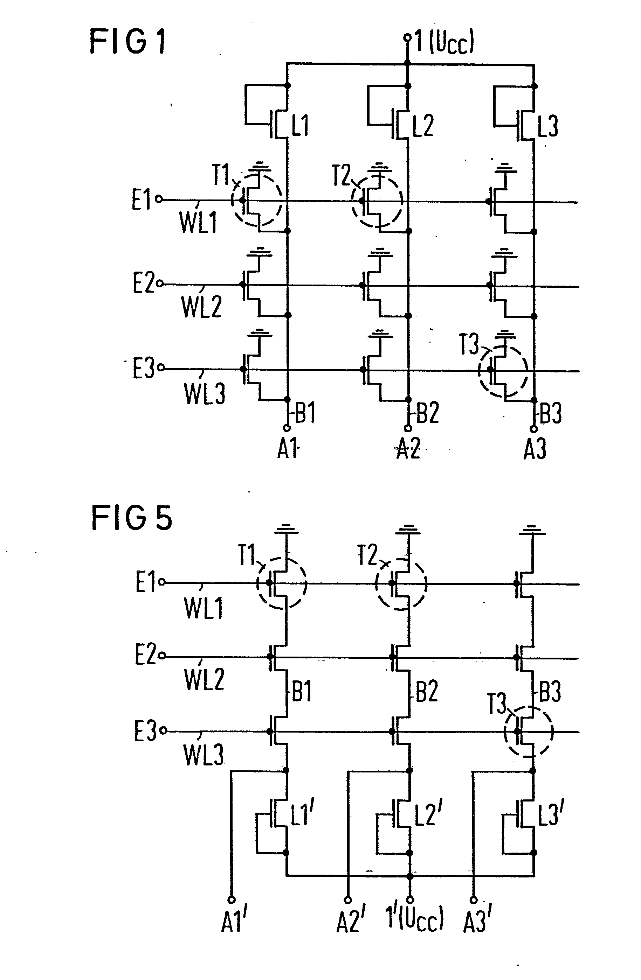

In Figur 1 ist das Schaltbild einer Festwertspeichermatrix
angegeben, die drei zueinander parallele Wortleitungen WL1
bis WL3 und drei diese kreuzende Leseleitungen B1 bis B3
umfaßt. Die Wortleitungen WL1 bis WL3 weisen linksseitige
Anschlüsse E1 bis E3 auf, die mit entsprechenden Ausgängen
einer nicht dargestellten Zeilenauswahlschaltung, z.B. eines Wortdekoders, verbunden sind. Die Leseleitungen B1 bis
B3, die auch als Bitleitungen bezeichnet werden, sind über
Lastelemente L1 bis L3 mit einem Anschluß 1 verbunden, der
mit einer Versorgungsspannung $U_{cc}$ beschaltet ist. Die
Lastelemente bestehen dabei z.B. aus Feldeffekttransistoren des Verarmungstyps, deren Gateelektroden mit ihren
Drainanschlüssen verbunden sind. Die unteren Enden der
Leseleitungen B1 bis B3 sind mit den Ausgängen A1 bis A3
der Festwertspeichermatrix beschaltet. An allen Kreuzungsstellen zwischen den Leitungen WL1 bis WL3 und B1 bis
B3 sind Feldeffekttransistoren vorgesehen. Von diesen ist
der an der Kreuzungsstelle von WL1 und B1 befindliche
Transistor mit T1 bezeichnet. Seine Gateelektrode ist mit der Wortleitung WL1 verbunden, sein Drainanschluß mit der Leseleitung B1 und sein Sourceanschluß mit einem auf Bezugspotential liegenden Schaltungspunkt. Die übrigen Kreuzungsstellen sind mit entsprechenden Feldeffekttransistoren versehen.

In Figur 1 wird davon ausgegangen, daß die Festwertspeichermatrix so programmiert ist, daß die mit T1, T2 und T3 angedeuteten, mit gestrichelten Umrandungen versehenen Transistoren als Kopplungselemente dienen, die übrigen Transistoren dagegen nicht. In diesem Fall bewirkt ein von der Zeilenauswahlschaltung geliefertes, dem Anschluß E1 zugeführtes erstes binäres Signal, z.B. eine logische "1", daß die Transistoren T1 und T2 in den leitenden Zustand versetzt werden. Hierbei werden die Leseleitungen B1 und B2 über T1 und T2 jeweils auf das Bezugspotential gelegt, so daß an den Ausgängen A1 und A2 jeweils ein zweites binäres Signal, in diesem Fall eine logische "0", auftritt, während die Leseleitung  B3 etwa auf der Spannung $U_{cc}$ liegt. Wird andererseits ein erstes binäres Signal "1" am Eingang E3 empfangen, so wird lediglich am Ausgang A3 ein entsprechendes zweites binäres Signal "0" auftreten, während die Leitungen B1 und B2 etwa auf der Spannung $U_{cc}$ liegen bleiben. Beim Ansteuern des Eingangs E2 bleiben alle Leseleitungen B1 bis B3 und damit alle Ausgänge A1 bis A3 etwa auf der Versorgungsspannung $U_{cc}$, da über WL2 keine Kopplungselemente ansteuerbar sind.

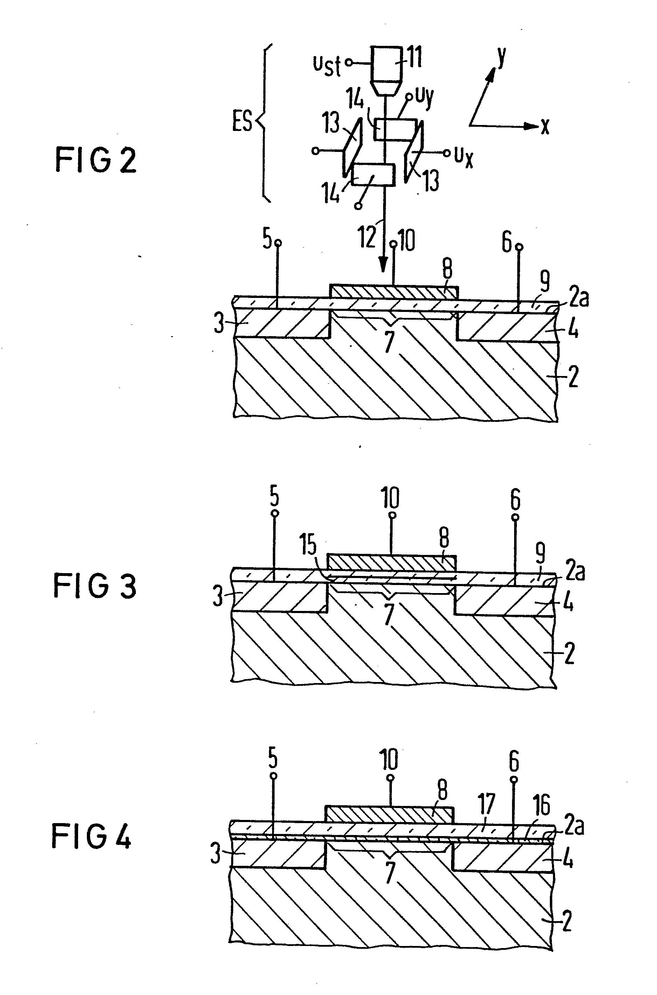

Es muß nun sichergestellt werden, daß trotz der an allen Kreuzungsstellen vorgesehenen Feldeffekttransistoren lediglich die Transistoren T1, T2, und T3 als Kopplungselemente wirken. Zu diesem Zweck werden die Einsatzspannungen von T1, T2 und T3 gegenüber den Einsatzspannungen der übrigen Transistoren verschoben, wie nachfolgend im einzelnen an Hand des Transistors T1 erläutert werden soll. Dieser ist in Figur 2 im Schnitt dargestellt. Er ist in einen z.B. aus Silizium bestehenden Halbleiterkörper 2 integriert und bei einer p-Dotierung desselben als eine N-Kanal-MIS-Struktur des Anreicherungstyps ausgebildet, wobei unter einer MIS-Struktur ganz allgemein eine Struktur verstanden wird, die einen Halbleiterkörper und einen durch eine elektrisch isolierende Schicht von diesem getrennte metallische Schicht umfaßt. T1 weist in Figur 2 mit 3 und 4 bezeichnete, in den Halbleiterkörper 2 eingefügte, $n^+$-dotierte Source- und Draingebiete auf, die sich bis zur Grenzfläche 2a des Halbleiterkörpers 2 erstrecken und mit Anschlüssen 5 und 6 versehen sind. Zwischen den Gebieten 3 und 4 befindet sich an der Grenzfläche 2a der Kanalbereich 7, der von einer metallisch leitenden Gateelektrode 8 überdeckt ist, die durch eine Gate-Isolierschicht 9, z.B. aus $SiO_2$, von der Grenzfläche 2a getrennt ist. Die Gateelektrode 8 besitzt einen Anschluß 10.

In Figur 2 ist weiterhin ein Elektronenstrahlschreiber ES angedeutet, der mit einer Elektronenkanone 11 versehen ist. Ein von dieser ausgehender Elektronenstrahl 12 wird durch zwei Ablenksysteme mit den Plattenpaaren 13 und 14, die jeweils mit Spannungen $u_x$ und $u_y$ beschaltet sind, in den Richtungen x und y abgelenkt. Der scharf fokussierte Elektronenstrahl 12 überstreicht nun in Abhängigkeit von den Spannungen $u_x$ und $u_y$ die Oberfläche des Halbleiterkörpers 2 beispielsweise in einzelnen parallel zueinander verlaufenden Zeilen. Ein derartiger Elektronenstrahlschreiber, der lediglich an Stelle von elektrostatischen Ablenksystemen 13 und 14 mit magnetischen Ablenksystemen ausgestattet ist, kann der Zeitschrift Philips techn. Rundschau 35, 1975/76, Nr. 3, Seiten 72-84, insbesondere Seite 73, Bild 1, entnommen werden.

Der Elektronenstrahl 12 wird durch eine zugeführte Steuerspannung $u_{st}$ jeweils nur dann eingeschaltet, wenn er gerade den Kanalbereich 7 überstreicht. Bei einer Stromdichte des Elektronenstrahls 12 vom z.B. $1 A/cm^2$, einer Beschleunigungsspannung von etwa 25 keV und einer lokalen Einwirkungsdauer von etwa $10^{-6}$s bilden sich in der Gate-Isolierschicht 9 Ladungsträgerpaare, von denen jeweils die negativen Ladungsträger in den mit einem Bezugspotential
beschalteten Halbleiterkörper 2 abfließen, während die
positiven Ladungsträger in der Gate-Isolierschicht 9 verbleiben und diese positiv aufladen. Eine Aufladung annähernd gleicher Größe ergibt sich aber auch für eine
Stromdichte von 100 $A/cm^2$ und eine Einwirkungsdauer von
$10^{-8}$s bei gleichbleibender Beschleunigungsspannung. Hieraus ist ersichtlich, daß die Größe der positiven Aufladung im wesentlichen von dem Produkt aus Stromdichte und
Einwirkungsdauer abhängt. Die genannten Zahlenwerte sind
jedoch nur beispielsweise Angaben und können im Rahmen der
Erfindung je nach der Größe der gewünschten positiven Aufladung variert werden.


Durch die positive Aufladung der Gate-Isolierschicht 9 verschiebt sich die Einsatzspannung $U_t$ des N-Kanal-Transistors
T1 auf einen niedrigeren Wert. In gleicher Weise werden
dann die Einsatzspannungen von T2 und T3 verschoben. Liegen
die Einsatzspannungen von T1, T2 und T3 beispielsweise auf
1 V, während die der übrigen Transistoren etwa 10 V betragen, und erfolgt die Ansteuerung an den Anschlüssen E1 bis
E3 mit etwa 5 V (logische "1") bzw. 0 V (logische "0"), so
werden bei einer Versorgungsspannung $U_{cc}$ von z.B. 12 V die
oben beschriebenen Verknüpfungen zwischen den Signalen an
E1 bis E3 und an A1 bis A3 erreicht.

Eine selektive Verschiebung der Einsatzspannungen von T1,
T2 und T3 kann auch in der Weise erfolgen, daß zunächst
die Einsatzspannungen aller Feldeffekttransistoren durch
eine gemeinsame Bestrahlung mit Röntgenstrahlen oder mit
dem Elektronenstrahl eines Elektronenstrahlschreibers, dessen Stromdichte, Einwirkungsdauer und Beschleunigungsspannung in der beschriebenen Weise gewählt sind, jeweils auf einen niedrigeren Wert verschoben werden und daß danach eine zusätzliche selektive Bestrahlung der Kanalbereiche der in Fig. 1 nicht bezeichneten Transistoren, deren Einsatzspannungen nicht verändert werden sollen, mit einem Elektronenstrahl 12 sehr großer Leistungsdichte erfolgt. Diese Leistungsdichte wird so gewählt, daß sich die Gate-Isolierschicht 9 der letzt genannten Transistoren jeweils auf eine Temperatur von etwa 500 bis 600°C erwärmt, wobei die gespeicherten positiven Ladungsträger in den Halbleiterkörper 2 abfließen, so daß die Gate-Isolierschicht wieder entladen und der ursprüngliche Wert der Einsatzspannung wieder erreicht wird. Hierbei kommen z.B. eine Stromdichte von 100 bis 500 $A/cm^2$ und eine lokale Einwirkungsdauer von $10^{-4}$s bei einer Beschleunigungsspannung von 25 keV in Betracht.

Vorteilhafte Weiterbildungen der Feldeffekttransistoren sind in den Figuren 3 und 4 dargestellt. In Figur 3 ist eine Polisiliziumschicht 15, die von äußeren Potentialen freigeschaltet ist und sich daher in einem Zustand des "floating" befindet, in die Gate-Isolierschicht 9 eingefügt. Nach Figur 4 besteht die Gate-Isolierschicht 9 aus zwei verschiedenen Teilschichten, z.B. aus einer $SiO_2$-Schicht 16 und einer darüberliegenden $Si_3N_4$-Schicht 17. Bei diesen Ausführungen der Transistoren werden die Ladungszustände der Gate-Isolierschichten durch die leitende Schicht 15 oder durch die Grenzfläche zwischen den Teilschichten 16 und 17 jeweils stabilisiert.

Eine andere Möglichkeit der Programmierung der Festwertspeichermatrix nach Fig. 1 besteht darin, daß die Einsatzspannungen der dort nicht bezeichneten Feldeffekttransistoren durch eine negative Aufladung ihrer Gate-Isolierschichten in Richtung auf größere Werte verschoben werden. Zu diesem Zweck werden vorteilhafterweise gemäß den Figuren 3 oder 4 weitergebildete Transistoren verwendet, deren Po-

lisiliziumschichten 15 oder deren Grenzflächen zwischen den Teilschichten 16 und 17 in herkömmlicher Weise negativ aufgeladen werden. Eine solche negative Aufladung wird beispielsweise in "A Users Handbook of Semiconductor Memories" von E.R. Hnafek, Verlag John Wiley & Sons, New York, 1977, Seiten 242-245 und 248, 249 oder in den Siemens Forschungs- und Entwicklungsberichten, Band 4 (1975), Nr. 6, Seiten 345-351 beschrieben. In vielen Fällen wird es zweckmäßig sein, zunächst die Gate-Isolierschichten aller Transistoren in dieser Weise negativ aufzuladen und anschließend eine selektive Bestrahlung der Kanalbereiche 7 der Transistoren T1, T2 und T3 mit dem Elektronenstrahl 12 vorzunehmen, dessen Stromdichte, Einwirkungsdauer und Beschleunigungsspannung in der bereits beschriebenen Weise gewählt sind, so daß sich die Gate-Isolierschichten von T1, T2 und T4 auf eine Temperatur erwärmen, bei der sie sich entladen. Dabei nehmen diese Transistoren wieder ihre ursprüngliche Einsatzspannung an, während die Verschiebung der Einsatzspannungen aller in Fig. 1 nicht bezeichneten Transistoren auf einen größeren Wert bestehen bleibt.

In Fig. 5 ist das Schaltbild einer weiteren nach der Erfindung ausgebildeten Festwertspeichermatrix dargestellt, die eine noch höhere Packungsdichte auf dem Halbleiterkörper 2 erlaubt als die Matrix nach Fig. 1. Zum Unterschied von Fig. 1 sind die Leseleitungen B1 bis B3 an ihren unteren Enden mit Lastelementen L1' bis L3' versehen, die insbesondere als Feldeffekttransistoren des Anreicherungstyps mit miteinander verbundenen Gate- und Drainanschlüssen ausgebildet sind. Die Drainanschlüsse von L1' bis L3' sind an einen gemeinsamen Anschluß 1' geführt, der mit der Versorgungsspannung $U_{cc}$ beschaltet ist. Die oberen Enden der Leseleitungen B1 bis B3 liegen auf Bezugspotential, während die Matrixausgänge A1' bis A3' an die den Kreuzungsstellen zugewandten Enden der Lastelemente L1' bis L3' geschaltet sind. Die Feldeffekttransistoren an den Kreuzungsstellen sind mit ihren Source-Drain-Strecken jeweils in die betreffenden Leseleitungen B1 bis B3 eingefügt, während ihre Gateelektroden wie in Fig. 1 mit den zugeordneten Wortleitungen WL1 bis WL3 verbunden sind.

Bei einer Ansteuerung über E1 bis E3 mit OV (logische "0") oder 5 V (logische "1") wird die jeweils selektierte Wortleitung, z.B. WL1, mit OV belegt. Da T1 und T2 wieder als Kopplungselemente dienen sollen, sind ihre Einsatzspannungen (ebenso wie die von T3) auf etwa -10 V verschoben, während die der übrigen Transistoren auf +1 V liegen. Dementsprechend werden T0 und T1 in den leitenden Zustand versetzt, während der Feldeffekttransistor an der Kreuzungsstelle von WL1 und B3 gesperrt ist. Da die nichtselektierten Wortleitungen WL2 und WL3 auf +5 V liegen, sind die über sie ansteuerbaren Transistoren leitend geschaltet. Die Ausgänge A1' und A2' sind also bei selektierter Wortleitung WL 1 auf Bezugspotential gelegt, während der Ausgang A3' etwa an der Spannung $U_{cc}$ liegt. Wird WL 2 selektiert, so liegen alle Ausgänge A1' bis A3' auf $U_{cc}$, während bei Selektion von WL3 nur A3' auf Bezugspotential liegt, während A1' und A2' mit $U_{cc}$ beschaltet sind.

Für den Fall, daß der Halbleiterkörper 2 n-dotiert ist und die Feldeffekttransistoren als P-Kanal-MIS-Strukturen realisiert sind, müssen ihre Einsatzspannungen jeweils in entgegengesetzter Richtung verschoben werden. Hierzu kann man die bereits beschriebenen Maßnahmen heranziehen, wenn man beachtet, daß die bisher auf die Transistoren T1 bis T3 angewendeten Maßnahmen nunmehr auf die in Fig. 1 oder Fig. 5 nicht bezeichneten Transistoren anzuwenden sind und umgekehrt.

6 Patentansprüche
5 Figuren

<u>Patentansprüche</u>

1. Monolithisch integrierter Festwertspeicher mit einer Mehrzahl von Wortleitungen, einer Mehrzahl von die Wortleitungen kreuzenden Leseleitungen, die über endseitige Lastelemente mit einem Versorgungsspannungsanschluß verbunden sind, und mit an selektierten Kreuzungsstellen angeordneten, über die Wortleitungen ansteuerbaren Feldeffekttransistoren, die jeweils als Kopplungselemente zwischen den Leseleitungen und einem ein Bezugspotential führenden Schaltungspunkt dienen, d a d u r c h  g e - k e n n z e i c h n e t ,  daß an allen Kreuzungsstellen Feldeffekttransistoren angeordnet sind, wobei lediglich die Gate-Isolierschichten (9) der an den (nicht) selektierten Kreuzungsstellen angeordneten Feldeffekttransistoren (T1, T2,T3) mittels eines ihre Kanalbereiche (7) wenigstens teilweise abtastenden Elektronenstrahls (12) in ihren Ladungszuständen derart verändert sind, daß die hierdurch bedingten Änderungen ihrer Einsatzspannungen ihren (Nicht-) Einsatz als Kopplungselemente bestimmen.

2. Monolithisch integrierter Festwertspeicher nach Anspruch 1, d a d u r c h  g e k e n n z e i c h n e t , daß in die Gate-Isolierschichten (9) der Feldeffekttransistoren (T1,T2,T3) jeweils leitende Schichten (15) oder Störstellen eingefügt sind, die die Ladungszustände derselben stabilisieren.

3. Monolithisch integrierter Festwertspeicher nach Anspruch 1, d a d u r c h  g e k e n n z e i c h n e t , daß die Feldeffekttransistoren (T1,T2,T3) als MNOS-Transistoren ausgebildet sind, deren Gate-Isolierschichten jeweils aus einer $SiO_2$-Schicht (16) und einer darüberliegenden $Si_3N_4$-Schicht (17) bestehen.

4. Verfahren zum Programmieren eines monolithisch integrierten Festwertspeichers nach einem der Ansprüche 1 bis

0046550

3, dadurch gekennzeichnet, daß der Elektronenstrahl (12) eines Elektronenstrahlschreibers (ES) derart abgelenkt wird, daß er selektiv die Kanalbereiche (7) der als Kopplungselemente dienenden Feldeffekttransistoren (T1,T2,T3) oder einen Teil derselben überstreicht, und daß die Stromdichte, Einwirkungsdauer und Beschleunigungsspannung des Elektronenstrahls (12) so gewählt sind, daß er in den Gate-Isolierschichten (9) eine positive Ladung erzeugt, die den Wert der Einsatzspannung dieser Feldeffekttransistoren (T1, T2, T3) von einem ohne diese Aufladung bestehenden niedrigeren Wert auf einen höheren Wert verschiebt oder umgekehrt.

5. Verfahren zum Programmieren eines monolithisch integrierten Festwertspeichers nach einem der Ansprüche 1 bis 3, dadurch gekennzeichnet, daß alle an den Kreuzungsstellen vorgesehenen Feldeffekttransistoren zunächst durch eine Bestrahlung mit Röntgenstrahlen oder mit einem von einem Elektronenstrahlschreiber (ES) erzeugten Elektronenstrahl (12), dessen Stromdichte, Einwirkungsdauer und Beschleunigungsdauer so gewählt sind, daß die Gate-Isolierschichten (9) der Feldeffekttransistoren positiv aufgeladen werden, eine gemeinsame Verschiebung ihrer Einsatzspannungen erfahren und daß danach eine selektive Bestrahlung der Kanalbereiche (7) der (nicht) an den selektierten Kreuzungsstellen befindlichen Feldeffekttransistoren mit einem Elektronenstrahl erfolgt, dessen Stromdichte, Einwirkungsdauer und Beschleunigungsspannung so gewählt sind, daß die Gate-Isolierschichten (9) dieser Feldeffekttransistoren sich auf eine Temperatur erwärmen, bei der sie wieder entladen werden, so daß die Einsatzspannungen dieser Feldeffekttransistoren wieder ihren ursprünglichen Wert annehmen.

6. Verfahren zum Programmieren eines monolithisch integrierten Feldwertspeichers nach einem der Ansprüche 1 bis 3, dadurch gekennzeichnet, daß

**0046550**

die Gate-Isolierschichten aller an den Kreuzungsstellen befindlichen Feldeffekttransistoren zunächst in an sich bekannter Weise negativ aufgeladen werden, so daß die Feldeffekttransistoren eine gemeinsame Verschiebung ihrer Einsatzspannungen erfahren und daß danach eine selektive Bestrahlung der Kanalbereiche der an selektierten (nicht selektierten) Kreuzungsstellen befindlichen Feldeffekttransistoren mit dem Elektronenstrahl (12) eines Elektronenstrahlschreibers (ES) erfolgt, dessen Stromdichte, Einwirkungsdauer und Beschleunigungsspannung so gewählt sind, daß die Gate-Isolierschichten dieser Feldeffekttransistoren sich auf eine Temperatur erwärmen, bei der sie wieder entladen werden, so daß die zuletzt genannten Feldeffekttransistoren eine Einsatzspannung aufweisen, die dem ursprünglichen, ohne die aufgebrachte negative Ladung vor- handenen Wert entspricht.

## FIG 1

## FIG 5

FIG 2

FIG 3

FIG 4

Europäisches
Patentamt

**EUROPÄISCHER RECHERCHENBERICHT**

Nummer der Anmeldung

EP 81 10 6343

| | EINSCHLÄGIGE DOKUMENTE | | KLASSIFIKATION DER ANMELDUNG (Int. Cl.³) |
|---|---|---|---|
| Kategorie | Kennzeichnung des Dokuments mit Angabe, soweit erforderlich, der maßgeblichen Teile | betrifft Anspruch | |
| | <u>US - A - 3 721 962</u> (N.C.R.)<br><br>* Spalte 3, Zeile 16 - Spalte 4, Zeile 59 *<br><br>-- | 1,4-6 | G 11 C 11/34<br>17/00 |
| | PROCEEDINGS OF THE IEEE, Band 56, Nr. 2, Februar 1968, Seiten 158-166<br>New York, U.S.A.<br>N.C. MacDONALD et al.: "An electron beam activated switch and associated memory"<br><br>* Seiten 158-161 *<br><br>-- | 1,4-6 | |
| | IEEE JOURNAL OF SOLID STATE CIRCUITS, Band SC-14, Nr. 5, Oktober 1979, Seiten 855-859<br>New York, U.S.A.<br>K. KIUCHI et al.: "A 65 mW 128K EB-ROM"<br><br>* Insgesamt *<br><br>-- | 1,3-6 | RECHERCHIERTE SACHGEBIETE (Int. Cl.³)<br><br>G 11 C 11/34<br>17/00 |
| | <u>DE - A - 2 263 392</u> (DEUTSCHE FOR-SCHUNGS- UND VERSUCHSANSTALT FUR LUFT- UND RAUMFAHRT)<br><br>* Seite 2, Zeile 21 - Seite 6, Zeile 11 *<br><br>-- | 1,3-6 | |
| | <u>US - A - 3 925 767</u> (SINGER CO.)<br><br>* Spalte 2, Zeilen 37-66; Spalte 4, Zeile 46 - Spalte 5, Zeile 5 *<br><br>-- | 1-6 | KATEGORIE DER GENANNTEN DOKUMENTE<br><br>X: von besonderer Bedeutung<br>A: technologischer Hintergrund<br>O: nichtschriftliche Offenbarung<br>P: Zwischenliteratur<br>T: der Erfindung zugrunde liegende Theorien oder Grundsätze<br>E: kollidierende Anmeldung<br>D: in der Anmeldung angeführtes Dokument |
| A | PROCEEDINGS OF THE IEEE, Band 64, Nr. 7, Juli 1976, Seiten 1039-1059 | 2,3 | L: aus andern Gründen angeführtes Dokument<br>&: Mitglied der gleichen Patentfamilie, übereinstimmendes Dokument |

Der vorliegende Recherchenbericht wurde für alle Patentansprüche erstellt.

| Recherchenort | Abschlußdatum der Recherche | Prüfer |
|---|---|---|
| Den Haag | 20-11-1981 | DEGRAEVE |

EPA form 1503.1 06.78

Nummer der Anmeldung

EP 81 10 6343
-2-

Europäisches
Patentamt

**EUROPÄISCHER RECHERCHENBERICHT**

| | **EINSCHLÄGIGE DOKUMENTE** | | **KLASSIFIKATION DER ANMELDUNG (Int. Cl.³)** |
|---|---|---|---|
| Kategorie | Kennzeichnung des Dokuments mit Angabe, soweit erforderlich, der Maßgeblichen Teile | betrifft Anspruch | |
| | J.J. CHANG: "Nonvolatile semiconductor memory devices" <br><br> * Teile II und III * <br><br> ---- | | |
| | | | **RECHERCHIERTE SACHGEBIETE (Int. Cl.³)** |